# EUROPEAN PATENT APPLICATION

(11) **EP 1 401 245 A1**
(43) Date of publication of application: **24.03.2004**
(21) Application number: 02741347.5
(22) Date of filing: 26.06.2002
(51) Int. Cl.: H05B 33/10, H05B 33/12, H05B 33/14

(54) **ELECTROLUMINESCENT ELEMENT**

(30) Priority: 27.06.2001 JP 2001194079
(71) Applicant: Sony Corporation, Tokyo 141-0001 (JP)
(72) Inventor: NISHIMURA, Teiichiro, c/o SONY CORPORATION, Tokyo 141-0001 (JP); NISHIGUCHI, Masao, c/o SONY CORPORATION, Tokyo 141-0001 (JP)
(74) Representative: Thévenet, Jean-Bruno
(86) International application number: PCT/JP2002/006444
(87) International publication number: WO 2003/003794

(57) **Abstract**

Disclosed is an electroluminescent device capable of forming a layer having a luminous resin, which has been regarded as impossible to be patterned, into a specific pattern while keeping high uniformity and good quality of the layer, selecting the viscosity of an ink material used for forming the layer in a wide range and also selecting a solvent used for preparing the ink material in a wide range, and shortening a time required for fabrication of the device. The electroluminescent device includes a transparent pixel electrode (2), a cathode composed of layers (9), (10), and (13), and a hole transport layer (4) and an electron transport emitting layer (5) which are disposed, as layers having a luminous region, between the transparent pixel electrode (2) and the cathode, wherein at least the electron transport emitting layer (5) is formed by transfer of a constituent material of the electron transport emitting layer (5) in accordance with a relief printing reverse offset method.

## Description

### Technical Field

The present invention relates to an electroluminescent device, for example, suitable for spontaneous luminescent type thin, flat displays and the like.

### Background Art

Lightweight, highly efficient flat panel displays have been extensively studied and developed, for example, for picture display of computers and television sets.

One of these flat panel displays is a cathode-ray tube (CRT), which is high in luminance and good in color reproducibility, and is therefore being used as the most popular display at present. The CRT, however, has problems that it is relatively heavy and bulky, and is high in power consumption.

To solve such problems, a liquid crystal display has been put into market as a lightweight, thin display and it is now becoming widely available; however, it also has problems inherent thereto, that is, narrow viewing angle and insufficient responsiveness to fast pixel signals. The liquid crystal display has a further problem in terms of fabrication. In particular, along with the tendency toward a larger screen of the liquid crystal display, the fabrication of the liquid crystal display becomes difficult, with the raised fabrication cost.

A display using light emitting diodes is often used in place of the liquid crystal display; however, it also has problems in terms of high fabrication cost and difficulty in formation of a matrix structure of light emitting diodes on one substrate.

As a flat panel display capable of solving these problems, an organic electroluminescent device (organic EL device) using an organic luminescent material becomes a focus of attention. Because the organic electroluminescent device using an organic compound as a luminescent material emits spontaneous light, it is expected as a flat panel display capable of realizing fast response speed and good image display with no dependence on viewing angle.

An electroluminescent device using an organic compound as a constituent material has been reported in Applied Physics Letters, 51, p. 913 (1987). In this report, C. W. Tang et al. disclose the electroluminescent device having a structure that an organic luminescent layer is stacked on a charge transport layer.

The report describes that the electroluminescent device having good characteristics can be obtained by using tris (8-quinolinol) aluminum complex (hereinafter, referred to as "Alq₃") exhibiting both a high luminous efficiency and an electron transpotability as a luminous material. C. W. Tang et al. also disclose, in Journal of Applied Physics, 65, p. 3610 (1989), an electroluminescent device characterized by doping Alq₃ forming an organic luminous layer with a phosphorous pigment such as a coumarin derivative or DCM1 (produced by Eastman Chemicals Inc.). This report describes that the luminous color of such a doped type organic electroluminescent device is changed by suitably selecting the kind of the pigment, and the luminous efficiency of the doped-type organic electroluminescent device is superior to that of a non-doped organic electroluminescent device.

Following the study on the organic electroluminescent device by C. W. Tang et al., various studies have been made to develop new functional materials, for example, phosphorous luminous chelate metal complexes, electron transportable organic molecules, and hole transportable organic molecules, and also various examinations have been made to develop full-color organic electroluminescent devices.

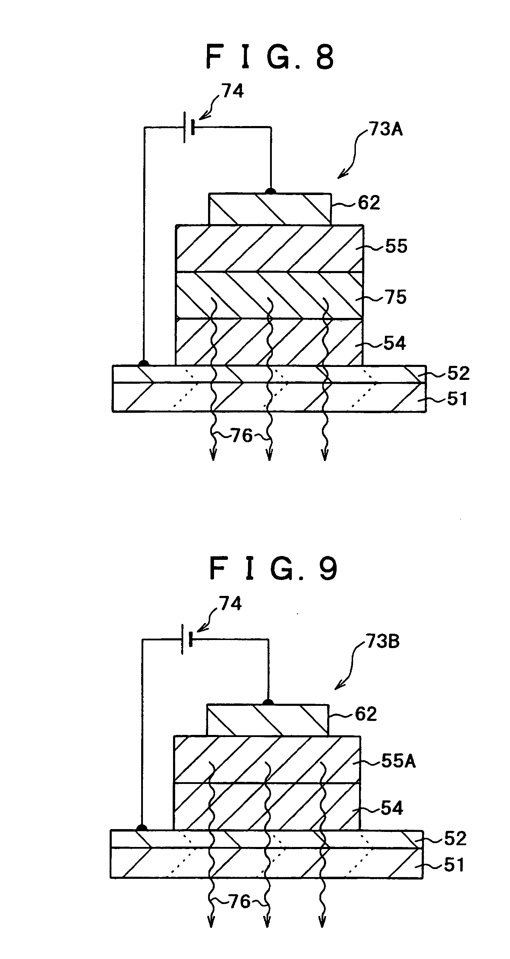

FIG. 8 shows one example of a related art organic electroluminescent device.

An organic electroluminescent (EL) device 73A is fabricated by sequentially forming, on a transparent glass substrate 51, a transparent pixel electrode (anode) 52 made from ITO (Indium Tin Oxide), a hole transport layer 54, a luminous layer 75, an electron transport layer 55, and a cathode 62, by a vacuum deposition process or the like.

The organic electroluminescent (EL) device 73A is operated as follows: namely, when a DC voltage 74 is applied between the ITO transparent pixel electrode 52 as an anode and the cathode 62, holes (positive holes) as carriers injected from the ITO transparent pixel electrode 52 migrate to the luminous layer 75 via the hole transport layer 54, while electrons injected from the cathode 62 migrate to the luminous layer 75 via the electron transport layer 55, to cause recombination of pairs of the electrons and holes, thereby producing luminescence 76 having a specific wavelength. The luminescence 76 is observable from the transparent glass substrate 51 side.

FIG. 9 shows another related art organic electroluminescent device 73B, in which an electron transport layer 55A serves as a luminous layer.

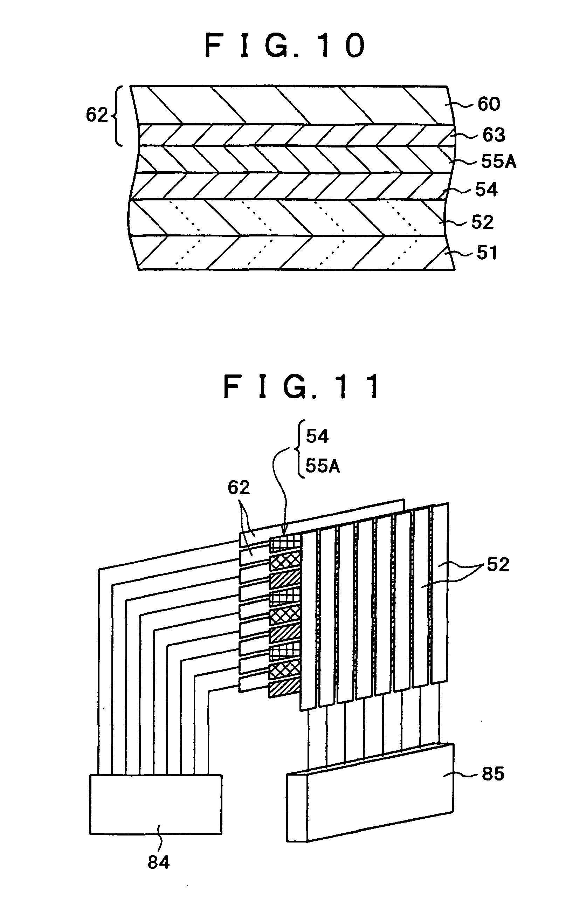

The structure of the organic electroluminescent layer 73B has a stacked structure shown in FIG. 10, in which a transparent pixel electrode (anode) 52 made from ITO is provided on a glass substrate 51, a hole transport layer 54 is formed on the pixel electrode 52, and an electron transport emitting layer 55A is formed on the hole transport layer 54, a calcium (Ca) layer 63 for increasing the injection characteristic of electrons is formed on the electron transport emitting layer 55A, and an aluminum (Al) layer 60 is formed on the calcium layer 63.

In the above layer structure of the organic electroluminescent (EL) device 73B, the hole transport layer 54 is made from poly(3,4)-ethylene dioxythiophene (hereinafter, referred to as "PEDOT"), and the electron transport emitting layer 55A is made from poly(2-methoxy-5-(2'-ethylhexyloxy)-1,4-phenylenevinylene) (hereinafter, referred to as "MEH-PPV"). It is to be noted that the calcium (Ca) layer 63 and the aluminum (Al) layer 60, which are formed on the hole transport layer 54 and the electron transport emitting layer 55A, constitute a cathode 62.

FIG. 11 shows a constitution example of a flat display using the organic electroluminescent device 73B shown in FIG. 10.

As shown in this figure, an organic stacked structure composed of the electron transport layer 55A and the hole transport layer 54 is disposed into a specific pattern between the cathodes 62 and the anodes 52. The cathodes 62 and the anodes 52 are formed into stripe shapes perpendicular to each other. A signal voltage is applied from a signal circuit 84 to a selected one of the cathodes 62 and a signal voltage is applied from a control circuit 85 in a shift register to a selected one of the anodes 52. As a result, the organic stacked structure emits light at a position (pixel) at which the selected cathode 62 and anode 52 cross each other.

In the conventional method of fabricating organic electroluminescent devices, an organic luminous layer such as an electron transport emitting layer and an electrode are mainly formed by a vacuum deposition process.

With respect to the recent display using organic electroluminescent devices, however, as the size thereof becomes large, deposition spots may occur in the step of forming a luminous layer or an electrode by vacuum deposition, failing to desirably form the luminous layer or the electrode by vacuum deposition. Further, an organic EL material has been regarded as impossible to be patterned after formation of a film of the organic EL material.

A method of fabricating a device using a polymer EL material has become a focus of attention from the viewpoint of solving the above problems. For example, a method of fabricating a polymer EL device using an ink jet printing technique has been known, for example, from Japanese Patent Laid-open No. Hei 10-153967.

This method, however, has a problem that since only a material having a low viscosity can be used for the ink jet printing and the ink jet head is of a droplet discharge type, it is required to form banks with a black resist (resin) for forming a pattern. To be more specific, portions, adhering on the black resist, of an ink material having a low viscosity are removed together with the black resist, with a result that the remaining ink material forms a specific pattern.

Other problems of this method are that as described in this document (Japanese Patent Laid-open No. Hei 10-153967), it is regarded that an ink material is preferably a water-soluble material or a material soluble in an alcohol or glycol based solvent from the relationship with the ink jet head, and therefore, the kind of solvent used for ink jet printing is limited, and that since a time required for ink jetting per unit area is determined, it takes a lot of time as the screen becomes large.

An object of the present invention is to provide an electroluminescent device capable of forming a layer having a luminous region, which has been regarded as impossible to be patterned, into a specific pattern while keeping high uniformity and good quality of the patterned layer, selecting the viscosity of a constituent material to be transferred in a wide range and also selecting a solvent used for transfer of the constituent material in a wide range, and shortening a time required for fabrication of the device.

### Disclosure of Invention

The present invention provides an electroluminescent device including a first electrode, a second electrode, and layers having a luminous region, which layers are provided between the first electrode and the second electrode, wherein at least one of the layers is formed into a specific pattern by transfer of a constituent material of the layer in accordance with a relief printing reverse offset method. The device configured as described above according to the present invention is hereinafter referred to as "electroluminescent device of the present invention".

According to the electroluminescent device of the present invention, since at least one of layers having a luminous region can be formed into a specific pattern by transfer of a constituent material of the layer in accordance with the relief printing reverse offset method, it is possible to form a material, which has been regarded as impossible to be patterned, into a specific pattern while keeping high uniformity and good quality of the patterned layer, to select the viscosity of the constituent material to be transferred in a wide range and also select a solvent used for transfer of the constituent material in a wide range, and to shorten a time required for transfer of the constituent material because of rapid transfer of each pattern. As a result, the electroluminescent device of the present invention is capable of sufficiently meeting the requirements for a large screen and full color display (which is realized by patterning materials of a plurality of colors), while ensuring a high luminous efficiency and a high luminous intensity.

### Brief Description of Drawings

FIGS. 1A to 1C are sectional views illustrating a relief printing reverse offset method used for fabrication of an organic electroluminescent device of the present invention in the order of fabrication steps;
FIGS. 2A to 2C are sectional views sequentially showing the steps of fabricating the organic electroluminescent device of the present invention;
FIGS. 3A to 3D are sectional views sequentially showing the steps of fabricating the organic electroluminescent device of the present invention;
FIGS. 4A to 4C are diagrams showing molecular structures of MEH-PPV, CN-PPV, and PPV as luminous materials used for fabrication of the organic electroluminescent device of the present invention, respectively;
FIG. 5 is a diagram showing a molecular structure of PEDOT;
FIGS. 6A and 6B are views showing patterns of an electron transport emitting layer of the organic electroluminescent device of the present invention;
FIG. 7A is a plan view of a pixel portion of the organic electroluminescent device of the present invention, and FIGS. 7B and 7C are sectional views taken on line A-A of FIG. 7A;
FIG. 8 is a schematic sectional view showing a related art organic electroluminescent device;
FIG. 9 is a schematic sectional view showing another related art organic electroluminescent device;
FIG. 10 is a sectional view showing a configuration of the organic electroluminescent device shown in FIG. 9; and
FIG. 11 is a schematic view showing a configuration example of a flat display using the organic electroluminescent devices shown in FIG. 9.

### Best Mode for Carrying Out the Invention

According to the present invention, preferably, the layer is formed into the specific pattern by transfer of an ink material composed of a solution in which the constituent material is dissolved in a solvent or a dispersant in which the constituent material is dispersed in the solvent, and removal of the solvent from the transferred ink material.

In this case, the layer may be formed into the specific pattern by preparing a member having an ink releasable surface by subjecting a surface of the member to an ink releasability imparting treatment, coating the ink releasable surface with the ink material composed of the solution or dispersant of the constituent material of the layer, pressing a relief made from glass or the like having projections arranged in a specific pattern to the ink releasable surface coated with the ink material, to remove portions, being in contact with the projections of the relief, of the ink material from the ink releasable surface by transfer, and transferring the ink material remaining on the ink releasable surface of the member into the specific pattern on a substrate made from glass or the like.

A luminous layer may be formed into the specific pattern by transfer of the ink material prepared by dissolving or dispersing an organic luminous material (for example, a polymer luminous material such as MEH-PPV, or a low molecular weight luminous material such as anthracene or phthalocyanine) or a precursor thereof in water or an organic solvent (for example, cyclohexanone, tetrahydrofuran (THF), xylene, dimethylformamide (DMF), dimethylsulfoxide (DMSO), or acetonitrile).

A composite layer (stacked structure) made from a polymer luminous material such as MEH-PPV or a precursor thereof and an organic material such as PEDOT or a precursor thereof by transfer of the ink material prepared by dissolving or dispersing the polymer luminous material or a precursor thereof and the organic material or a precursor thereof in water or an organic solvent (for example, cyclohexanone, tetrahydrofuran (THF), xylene, dimethylformamide (DMF), dimethylsulfoxide (DMSO), or acetonitrile).

An electron transport emitting layer may be formed on a hole transport layer by transfer of the ink material into the specific pattern. Further, a layer for a single color or each of layers for a plurality of colors may be formed by transfer of the ink material into the specific pattern.

For example, the layer may be formed into the specific pattern on electrodes patterned at least for respective pixels on a substrate made from glass or the like. Further, at least three kinds of luminous layers for emitting light of red, green and blue may be each formed into the specific pattern on electrodes patterned at least for respective pixels on a substrate made from glass or the like, by transferring each of ink materials of constituent materials of the luminous layers on the electrodes.

A preferred embodiment of the present invention will be hereinafter described in detail with reference to the drawings.

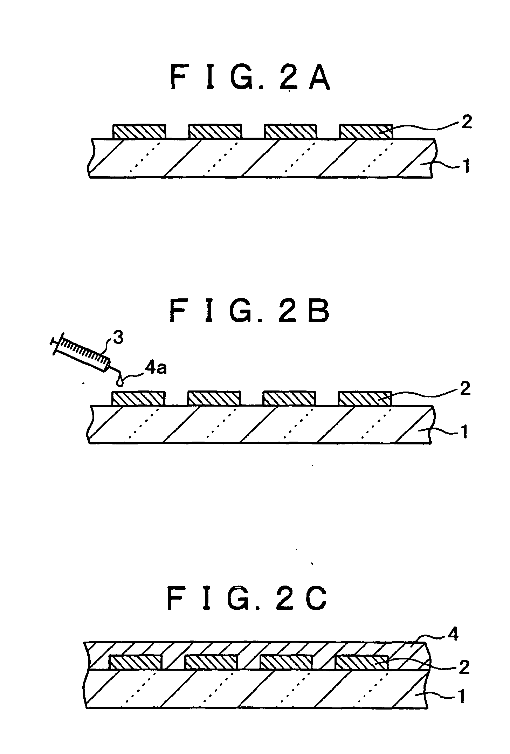

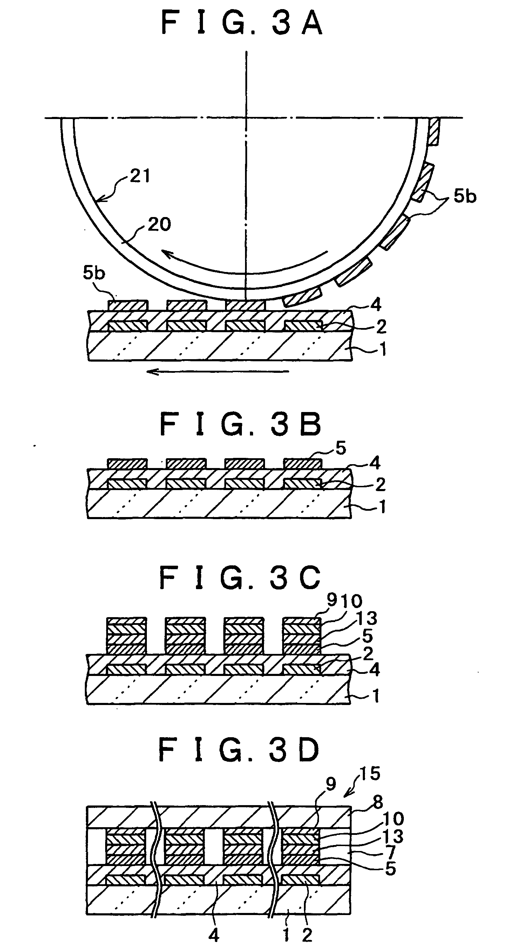

A process of fabricating an organic electroluminescent (EL) device according to a preferred embodiment of the present invention is shown in FIGS. 2A to 2C and FIGS. 3A to 3D.

As shown in FIG. 2A, a transparent glass substrate 1 having a hydrophobic surface is twice subjected to a substrate cleaning step, which step involves ultrasonic cleaning using a cleaning agent of Fisher brand and several times of cleaning using ultrapure water. The substrate 1 is then cleaned with acetone and isopropyl alcohol, and dried in a clean oven. After the substrate 1 is thus cleaned, transparent pixel electrodes (anodes) 2 made from ITO are formed on the substrate 1 by forming a layer made from ITO on the substrate 1 by vacuum deposition or the like and patterning the ITO layer in a specific pattern. In this step, the formation of the transparent pixel electrodes 2 is performed after and/or before irradiation of the substrate 1 with ultraviolet rays-ozone (UV-ozone).

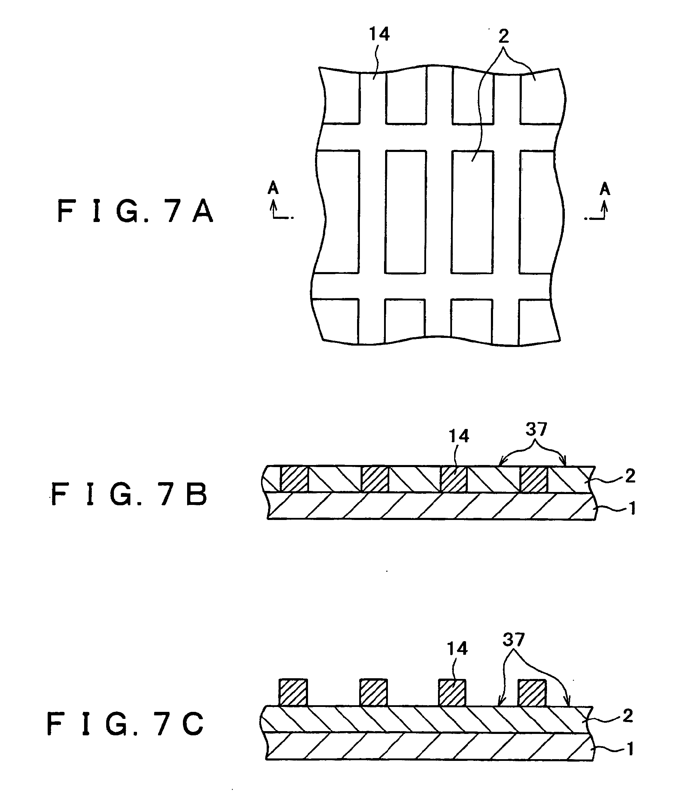

The pattern of the ITO transparent pixel electrodes 2 may be variously selected. One example of the pattern is shown in FIG. 7A, in which island-shaped pixel portions 37, each having a size of, for example, 70x200 nm, are independently arranged. As shown in FIGS. 7B and 7C, the adjacent two of the patterned pixel portions 37 may be insulated from each other by means of an insulator 14. Alternatively, the pixel electrodes 2 may be formed into stripe shapes.

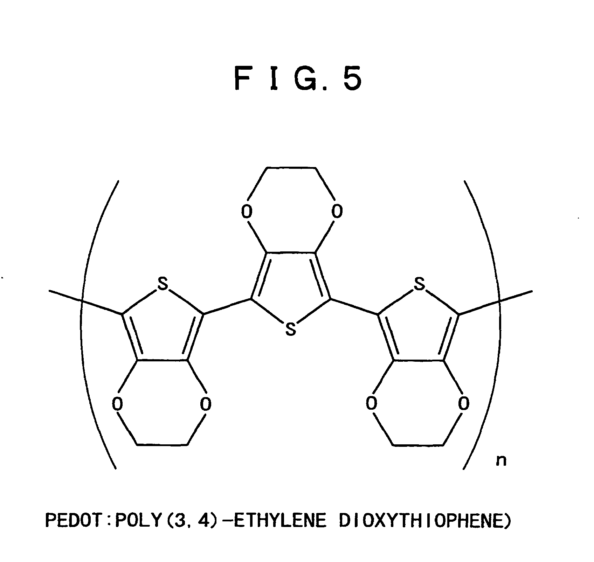

As shown in FIG. 2B, a solution 4a of PEDOT having a hole transportability, which has a molecular structure shown in FIG. 5, is dropped on the substrate 1 by means of a micro-syringe 3 under a dropping condition controlled in an atmospheric state. The dropped solution 4a of PEDOT is then subjected to spin coating at 600 rpm for 2 sec and 3000 rpm for 58 sec.

As shown in FIG. 2C, the resultant substrate 1 is placed on a hot plate and is baked, to form a hole transport layer 4 made from PEDOT. The baking treatment is performed in a treatment bath kept in an atmospheric state or a pressure-reduction state, with the baking temperature or the degree of pressure-reduction controlled, for example, at 120°C for 10 min.

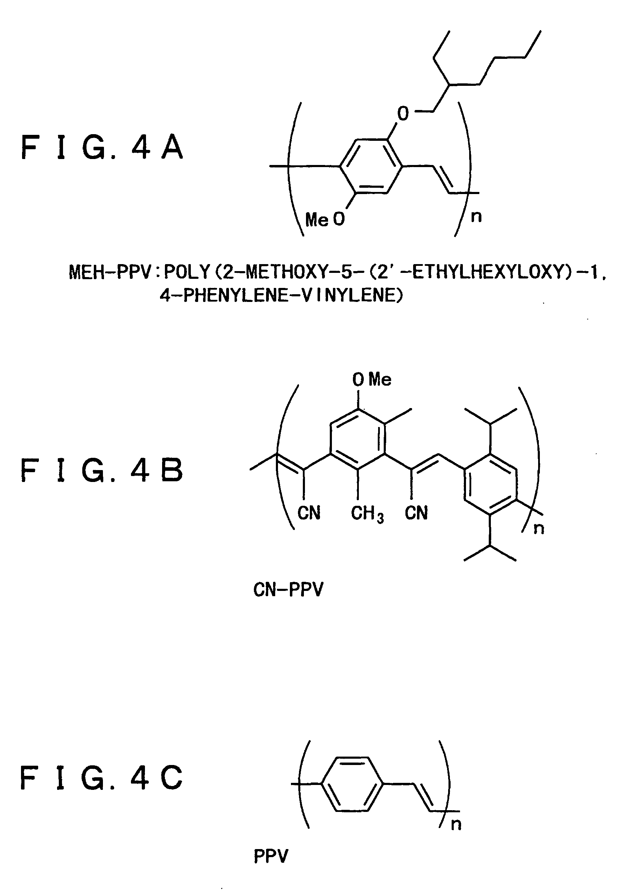

As shown in FIG. 3A, an ink material 5b composed of a water solution of MEH-PPV, CN-PPV, or PPV, which is an electron transportable polymer having a molecular structure shown in FIG. 4A, 4B or 4C, is transferred in a specific pattern onto the hole transport layer 4 by a relief printing reverse offset method.

The resultant substrate 1 is baked, for example, at 70°C for 2 hr, to form a film of the ink material 5b, and is then put in a vacuum oven kept at 70°C for evaporation of a solvent (water) remaining in the ink material 5b, to form an electron transport emitting layer 5 as shown in FIG. 3B.

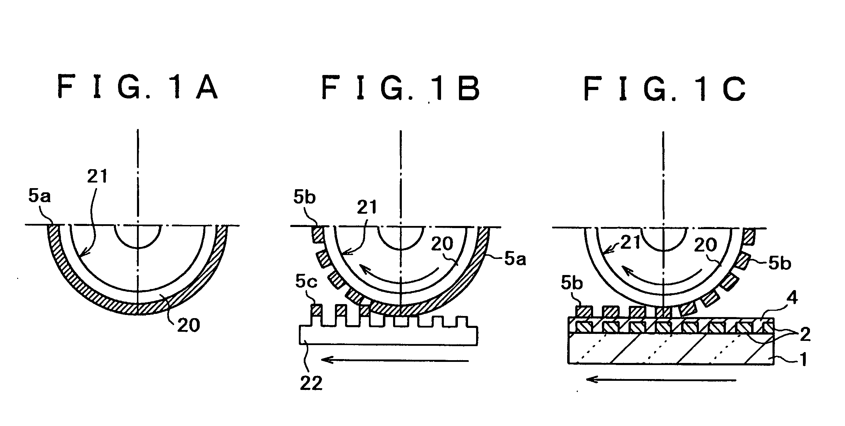

The transfer of the ink material 5b composed of a solution of PPV or a derivative thereof may be, as will be described below, performed by the relief printing reverse offset method shown in FIGS. 1A to 1C.

As shown in FIG. 1A, the surface of a silicon resin layer 20 integrally formed around a roll 21 is subjected to an ink releasability imparting treatment, and is coated with an ink material 5a to a specific thickness (for example, 100 nm) by a wire bar (not shown). As shown in FIG. 1B, the roll 21 is set such that the ink material 5a on the surface of the silicon resin layer 20 is brought into contact with leading ends of projections of a glass made relief (glass mask) 22, and is rotated relative to the relief 22, with a result that portions 5c of the ink material 5a, which are in contact with the leading ends of the projections of the relief 22, are removed from the surface of the silicon resin layer 20 of the roll 21. Such partial removal of the ink material 5a from the roll 21 side can be easily, highly accurately performed by the releasing function of the ink releasable surface of the silicon resin layer 20. It is to be noted that the projections of the relief 22 are previously formed into a pattern reversed to a pattern of an electron transport emitting layer to be formed.

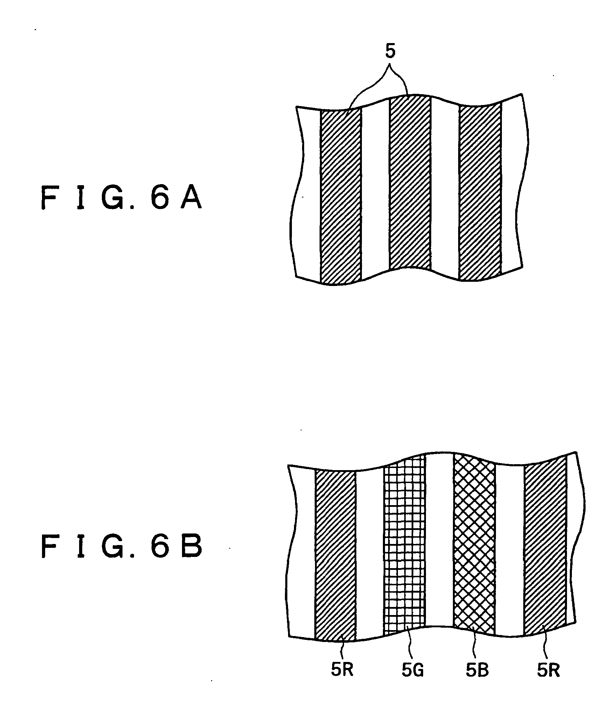

As shown in FIG. 1C, the roll 21 is set such that a necessary pattern of the ink material 5b remaining on the surface of the silicon resin layer 20 is brought into contact with the glass substrate 1 of an organic electroluminescent device, and is rotated relative to the substrate 1, to transfer the ink material 5b remaining on the surface of the silicon layer 20 of the roll 21 into a specific pattern on the substrate 1. The substrate 1 is then, as described above, subjected to the baking and drying treatments. Such transfer of the ink material 5b from the roll 21 side to the substrate 1 is easily, highly accurately performed by the releasing function of the ink releasable surface of the silicon resin layer 20 of the roll 21. The electron transport emitting layer 5 thus formed may have a single color pattern as shown in FIGS. 6A to 6C, and also have a full-color pattern composed of a combination of a single color pattern 5R (for red), a single color pattern 5G (for green), and a single color pattern 5B (for blue) as shown in FIGS. 7A to 7C.

As shown in FIG. 3C, a calcium (Ca) layer 13 having a thickness of, for example, 5,000 nm is formed on the electron transport emitting layer 5 by vacuum deposition or the like and patterning, an aluminum (Al) layer 10 having a thickness of, for example, 10,000 nm is formed on the calcium (Ca) layer 13 by vacuum deposition or the like and patterning, and an Au-Ge layer 9 for protection and improvement of a bonding characteristic is formed on the aluminum (Al) layer 10 by vacuum deposition or the like and patterning. These calcium (Ca) layer 13, the aluminum (Al) layer 10, and the Au-Ge layer 9 constitute a cathode.

As shown in FIG. 3D, a counter substrate 8 is placed on the Au-Ge layer 9, and a side portion is sealed with an epoxy resin or the like, to accomplish an organic electroluminescent device 15.

According to the organic electroluminescent device 15 in this embodiment thus fabricated, since at least one of layers having a luminous region, that is, the electron transport emitting layer 5 is formed into a specific pattern by transfer of a constituent material of the electron transport emitting layer 5 by the relief printing reverse offset method, it is possible to transfer even a constituent material, which has been regarded as impossible to be patterned, into the specific pattern while keeping high uniformity and good quality of the transferred layer.

According to this embodiment, it is also possible to select the viscosity of the constituent material to be transferred in a wide range, and to select the kind of the solvent in which the constituent material is dissolved in a wide range.

According to this embodiment, it is further possible to shorten a time required for transfer the constituent material because of rapid transfer of each pattern. As a result, the electroluminescent device according to this embodiment is capable of sufficiently meeting the requirements for a large screen and full color display (which is realized by patterning materials of a plurality of colors), while ensuring a high luminous efficiency and a high luminous intensity.

In particular, since the above-described relief printing reverse offset method is performed by coating the surface of the silicon resin layer 20 of the roll 21 with the ink material 5a, removing the unnecessary ink portions 5c by using the glass made relief 22, and transferring the ink material 5b remaining on the surface of the silicon resin layer 20 to the substrate 1 side, it is possible to eliminate a so-called stringiness phenomenon caused by release of the ink portions 5c and transfer of the ink material 5b can be eliminated, and hence to prevent occurrence of unevenness of the transferred ink material 5b. This makes it possible to easily, highly accurately obtain the desired pattern.

In this case, since the relief 22 is made from glass, the unnecessary ink portions 5c can be easily removed, and the necessary ink material 5b can be easily, highly adhesively transferred to the organic based hole transport layer 4 without getting out of the shape of the pattern. Even for a device structure provided with no hole transport layer 4, since the substrate to which the necessary ink material 5b is to be transferred is made from ITO or glass, the release and transfer of the necessary ink material 5b can be performed with the same ease as that of the release of the unnecessary ink portions 5c. As a result, it is possible to easily control the conditions for releasing the unnecessary ink portions 5c and releasing and transferring the necessary ink material 5b.

With the use of the relief 22, the unnecessary ink portions 5c can be easily removed from the surface of the silicon resin layer 20 and the necessary ink material 5b can be easily released from the surface of the silicon resin layer 20 and be easily transferred to a nearly flat surface, to improve the surface characteristic of the transferred ink material 5b, thereby forming a layer of the ink material 5b with high uniformity and high film quality. Since the relief 22 can be highly accurately obtained by etching, and particularly, the relief 22 having low projections (allowing formation of a thin ink layer) can be desirably obtained by etching, it is possible to desirably fabricate an organic electroluminescent device requiring the transfer of an ink layer having a small thickness.

The present invention will be more fully described by way of the following example.

### <Fabrication of Organic Electroluminescent Device>

A glass substrate was first irradiated with UV-ozone, and then a layer of ITO was formed on the substrate. The layer of ITO was patterned into a specific pattern as shown in FIGS. 7A to 7C, to form transparent pixel electrodes 2 on the substrate. The resultant substrate was irradiated with UV-ozone, if needed, and a solution of PEDOT was dropped on the substrate, followed by spin coating thereof at 600 rpm for 2 sec and at 3000 rpm for 58 sec. After the spin coating was terminated, the resultant substrate was baked at 120°C for 10 min by using a hot plate, to form a hole transport layer on the substrate so as to cover the pixel electrodes 2.

After the baking was terminated, an electron transport emitting material was printed into a specific pattern on the hole transport layer by the relief printing reverse offset method shown in FIGS. 1A to 1C, to form an electron transport emitting layer into a specific pattern. The relief printing reverse offset method was carried out by using an ink material in which each of MEH-PPV, CN-PPV, and PPV (having the following molecular structures) was dissolved as the electron transport emitting material in cyclohexanone as a solvent. After the printing was terminated, the resultant substrate was baked at 70°C for 2 hr, to form a film of the ink material containing the solvent, and was kept in a vacuum oven at 70°C to remove the solvent from the film of the ink material. 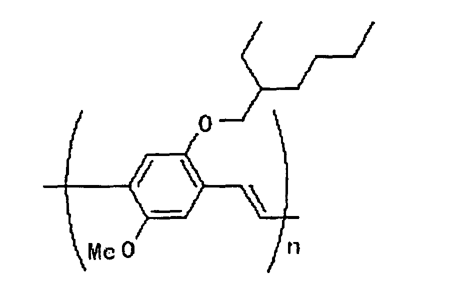 MEH-PPV (luminous color: orange, film thickness: 500 nm) 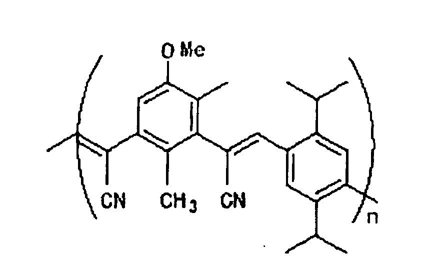 CN-PPV (luminous color: blue, film thickness: 430 nm) 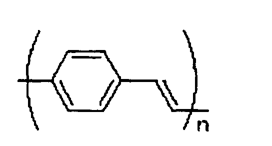 PPV (luminous color: green, film thickness: 525 nm)

A calcium (Ca) film having a thickness of 500 Å, an aluminum (Al) film having a thickness of 1,000 Å, and an Au-Ge film having a thickness of 1,000 Å were sequentially formed on the electron transport emitting layer by vacuum deposition, followed by patterning of these films, to form a cathode on the electron transport emitting layer. After the formation of the cathode was terminated, a side portion of the resultant substrate provided with the stacked structure was sealed with an epoxy resin, to fabricate an organic electroluminescent device as shown in FIG. 3D.

### <Evaluation of Luminous Characteristic>

Each of the three kinds of organic electroluminescent devices for emission of light of orange (using MEH-PPV), blue (using CN-PPV), and green (using PPV) was measured in terms of luminous efficiency (cd/A) and luminous intensity (cd/m²). The results are shown in Tables 1, 2 and 3. It is to be noted that in each of Tables 1, 2, and 3, the measured values of the luminous efficiency and the luminous intensity of an organic electroluminescent device fabricated such that an electron transport emitting layer was formed on a hole transport layer by forming a layer of PPV or a derivative thereof overall on the hole transport layer in accordance with the spin coating process are shown for comparison.

**Table 1**

| (using MEH-PPV) | | |
|---|---|---|
| | Luminous Efficiency (cd/A) | Luminous Intensity (cd/m²) |
| Relief Printing Reverse Offset Method | 2.1 | 1300 |
| Spin Coating | 2.0 | 1350 |

The organic electroluminescent device fabricated using MEH-PPV was subjected to a shelf test by leaving the device in a nitrogen atmosphere for one month, the result of which showed that any deterioration of the device was not observed. The device was then subjected to a forcible deterioration test by making the device continuously emit light under a condition of an initial luminance of 100 cd/m² by applying a constant current and measuring a time elapsed until the luminance was reduced to half, the result of which showed that the half-time was 1,300 hr.

**Table 2**

| (using CN-PPV) | | |
|---|---|---|
| | Luminous Efficiency (cd/A) | Luminous Intensity (cd/m²) |
| Relief Printing Reverse Offset Method | 1.2 | 1210 |
| Spin Coating | 1.3 | 1200 |

The organic electroluminescent device fabricated using CN-PPV was subjected to a shelf test by leaving the device in a nitrogen atmosphere for one month, the result of which showed that any deterioration of the device was not observed. The device was then subjected to a forcible deterioration test by making the device continuously emit light under a condition of an initial luminance of 100 cd/m² by applying a constant current and measuring a time elapsed until the luminance was reduced to half, the result of which showed that the half-time was 1,210 hr.

**Table 3**

| (using PPV) | | |
|---|---|---|
| | Luminous Efficiency (cd/A) | Luminous Intensity (cd/m²) |
| Relief Printing Reverse Offset Method | 2.3 | 1420 |
| Spin Coating | 2.4 | 1500 |

The organic electroluminescent device fabricated using PPV was subjected to a shelf test by leaving the device in a nitrogen atmosphere for one month, the result of which showed that any deterioration of the device was not observed. The device was then subjected to a forcible deterioration test by making the device continuously emit light under a condition of an initial luminance of 100 cd/m² by applying a constant current and measuring a time elapsed until the luminance was reduced to half, the result of which showed that the half-time was 1,450 hr.

The results of the above tables show that the organic electroluminescent device according to the embodiment of the present invention is able to facilitate the patterning of an organic luminous layer and to obtain desirable luminous characteristics, such as a luminous efficiency and a luminous intensity, comparable to those of an organic electroluminescent device fabricated by using the spin coating process. This is advantageous in fabricating an organic electroluminescent device for full-color display by forming organic luminous layers for emission of light of respective colors on a common substrate.

It is to be noted that the above-described preferred embodiment and the examples of the'present invention may be variously modified on the basis of the technical thought of the present invention.

For example, in fabrication of the above-described organic electroluminescent device, the luminous material to be transferred by the relief printing reverse offset method is not limited to PPV or a derivative thereof but may be any other organic or polymer luminous material, and the hole transport layer made from PEDOT may be similarly formed into a specific pattern by the relief printing reverse offset method.

The shape and structure of each member used for the relief printing reverse offset method, and the operating manner thereof may be variously changed.

The organic electroluminescent device fabricated according to the embodiment, which is for display, may be of any other structure, and further, it may be a device used as optical communication means for receiving electroluminescence produced by the device as signal light.

According to the electroluminescent device of the present invention, since at least one of layers having a luminous region is formed into a specific pattern by transfer of a constituent material of the layer in accordance with the relief printing reverse offset method, it is possible to form a material, which has been regarded as impossible to be patterned, into a specific pattern while keeping high uniformity and good quality of the patterned layer, to select the viscosity of the constituent material to be transferred in a wide range and also select a solvent used for transfer of the constituent material in a wide range, and to shorten a time required for transfer of the constituent material because of rapid transfer of each pattern. As a result, the electroluminescent device of the present invention is capable of sufficiently meeting the requirements for a large screen and full color display (which is realized by patterning materials of a plurality of colors), while ensuring a high luminous efficiency and a high luminous intensity.

## Claims

1. An electroluminescent device comprising:
a first electrode;
a second electrode; and
layers having a luminous region, which layers are provided between said first electrode and said second electrode;
wherein at least one of said layers is formed into a specific pattern by transfer of a constituent material of said layer in accordance with a relief printing reverse offset method.

2. An electroluminescent device according to claim 1, wherein said layer is formed into the specific pattern by transfer of an ink material composed of a solution in which the constituent material is dissolved in a solvent or a dispersant in which the constituent material is dispersed in the solvent, and removal of the solvent from the transferred ink material.

3. An electroluminescent device according to claim 2, wherein said layer is formed into the specific pattern by preparing a member having an ink releasable surface by subjecting a surface of said member to an ink releasability imparting treatment, coating the ink releasable surface with the ink material composed of the solution or dispersant of the constituent material of said layer, pressing a relief having projections arranged in a specific pattern to the ink releasable surface coated with the ink material, to remove portions, being in contact with the projections of the relief, of the ink material from the ink releasable surface by transfer, and transferring the ink material remaining on the ink releasable surface of said member into the specific pattern.

4. An electroluminescent device according to claim 2, wherein a luminous layer is formed into the specific pattern by transfer of the ink material prepared by dissolving or dispersing an organic luminous material or a precursor thereof in water or an organic solvent.

5. An electroluminescent device according to claim 2, wherein a composite layer made from a polymer luminous material or a precursor thereof and an organic material or a precursor thereof by transfer of the ink material prepared by dissolving or dispersing the polymer luminous material or a precursor thereof and the organic material or a precursor thereof in water or an organic solvent.

6. An electroluminescent device according to claim 2, wherein an electron transport emitting layer is formed on a hole transport layer by transfer of the ink material into the specific pattern.

7. An electroluminescent device according to claim 2, wherein a layer for a single color or each of layers for a plurality of colors is formed by transfer of the ink material into the specific pattern.

8. An electroluminescent device according to claim 7, wherein said layer is formed into the specific pattern on electrodes patterned at least for respective pixels on a substrate.

9. An electroluminescent device according to claim 7, wherein at least three kinds of luminous layers for emitting light of red, green and blue are each formed into the specific pattern on electrodes patterned at least for respective pixels on a substrate, by transferring each of ink materials of constituent materials of said luminous layers on said electrodes.
